# EUROPÄISCHE PATENTSCHRIFT

(11) **EP 3 025 318 B1**
(45) Veröffentlichungstag und Bekanntmachung des Hinweises auf die Patenterteilung: **01.11.2017**
(21) Anmeldenummer: 14737218.9
(22) Anmeldetag: 07.07.2014
(51) Int. Cl.: G08C 19/02, G05B 19/042

(54) **MESSGERÄT MIT EINER UMSCHALTBAREN MESS- UND BETRIEBSELEKTRONIK ZUR ÜBERMITTLUNG EINES MESSSIGNALS**
MEASURING INSTRUMENT HAVING A SWITCHABLE MEASURING AND OPERATING ELECTRONICS SYSTEM FOR TRANSMITTING A MEASUREMENT SIGNAL
APPAREIL DE MESURE DOTÉ D'UNE ÉLECTRONIQUE DE FONCTIONNEMENT ET DE MESURE COMMUTABLE SERVANT À LA COMMUNICATION D'UN SIGNAL DE MESURE

(30) Priorität: 24.07.2013 DE 102013107904
(43) Veröffentlichungstag der Anmeldung: 01.06.2016
(73) Patentinhaber: Endress+Hauser Flowtec AG, 4153 Reinach (BL) (CH)
(72) Erfinder: SIMON, Antoine, F-68300 St. Louis (FR); JENZER, Martin, CH-4144 Arlesheim (CH)
(74) Vertreter: Andres, Angelika Maria
(86) Internationale Anmeldenummer: PCT/EP2014/064455
(87) Internationale Veröffentlichungsnummer: WO 2015/010883

(56) Entgegenhaltungen:
- EP-A2- 2 226 515
- WO-A1-89/03618
- WO-A2-2011/009708
- DE-A1-102007 054 326

## Beschreibung

Die Erfindung betrifft ein Messgerät mit einer umstellbaren Mess- und Betriebselektronik zur Übermittlung eines Messsignals.

Die vorliegende Erfindung betrifft insbesondere ein Messgerät mit einem digitalen Messumformer, insbesondere einem Messumformer mit Stromsignal, bei dem also der Messwert durch eine Regelung eines Signalstroms bzw. eines Speisestroms ausgegeben wird. Digitale Messumformer sind solche, die mindestens einen Mikroprozessor zur Aufbereitung der Messsignale bzw. zur Steuerung interner Funktionen umfassen. Ein in der Industrie weit verbreiteter Standard zur Übermittlung von Messsignalen einer physikalischen und/oder chemischen Messgröße ist eine elektrische Stromschleife, z.B. eine Zwei-Leiter-Stromschleife. Über die Stromschleife ist das Messgerät mit einer Prozesssteuerung verbunden. Dabei wird der Messwert durch den Wert des eingestellten Stromes repräsentiert und der Strom durch die Prozesssteuerung erfasst. Der über die elektrische Stromschleife übertragene Strom liegt nach verbreitetem Industriestandard zwischen 0 mA und 20 mA.
Die DE102007054326A1 offenbart einen Messumformer, weicher ein Modem mit einer Empfangsschaltung aufweist, wobei der Messumformer zur Signalübertragung nach dem HART-Standard arbeitet.
Insbesondere in sicherheitsrelevanten Anwendungen ist es erforderlich, den Ausfall eines Messumformers bzw. seiner Komponenten mit ausreichend hoher Wahrscheinlichkeit erkennen zu können. In der NAMUR-Empfehlung NE43 wird beispielsweise vorgeschlagen, dass bei Messgeräten ein Messsignalstrom in einem Bandbereich zwischen 4 und 20 mA verwendet wird. Ein Geräteausfall wird mit einem Fehlersignalstrom außerhalb dieses Bandbereichs, z.B. nicht mehr als 3,6 mA bzw. mindestens 21 mA signalisiert. Hierbei entspricht ein in der Stromschleife eingestellter elektrischer Strom zwischen 4 Milliampère (mA) und 20 mA dem Messwert der physikalischen und/oder chemischen Messgröße.

Aufgrund von Driften und Ungenauigkeiten wird ein etwas größerer Strombereich zugelassen; bspw. ein Strom zwischen 3,8 mA und 20,5 mA. Ströme die kleiner als 3,6 mA bzw. größer als 21 mA sind, sollten von etwaigen Auswerteeinheiten nicht mehr als eine dem Messwert entsprechende Größe interpretiert werden. Ein in der Stromschleife eingestellter Strom kleiner als 3,6 mA oder größer als 21 mA wird daher als Fehlerstrom identifiziert.

Der analoge in der 2L-Stromschleife eingestellte Messsignalstrom wird typischer Weise durch einen Regelkreis in der 2L-Stromschleife eingestellt. Dabei ist wenigstens ein Teil der Mess- und Betriebselektronik Teil des Regelkreises. Zum Zwecke der Regelung wird die dem Istwert des Messsignalstroms entsprechende Rückführgröße von der Mess- und Betriebselektronik zurückgelesen und mit der dem Sollwert entsprechenden Führungsgröße verglichen. Üblicherweise wird die Führungsgröße von einer Steuereinheit ausgegeben. Die Steuereinheit gibt entsprechend Messsignalen eines Messaufnehmers oder Sensors die Führungsgröße aus. Bei einer Messwertänderung unterscheidet sich der in der 2L-Stromschleife eingestellte Istwert vom Sollwert. Aus der Regelabweichung zwischen Ist- und Sollwert wird die entsprechende Stellgröße erzeugt, mittels derer der Messsignalstrom in der 2L-Stromschleife verändert wird.

Eine ähnliche Schnittstelle für die Übertragung von Messsignalen und Statusinformationen in digitaler Form ist in EN 60947-5-6 (entsprechend IEC 60947-5-6) genormt. Die Betriebsparameter, dass heißt, der den digitalen Zuständen EIN und AUS zugeordnete Wert des Stromes im NAMUR-Betrieb, unterscheiden sich von den oben beschriebenen. Für die Übertragung von EN 60947-5-6-konformen FPS-Namur-Signalen (Frequency/Pulse/Status) beträgt hier der Stromwert für den EIN-Zustand von 2,2 mA bis 8 mA und der Stromwert für den AUS-Zustand von 0,35 mA bis 1,2 mA bei einer typischen Speisespannung von 8,2 V.

Liegen die tatsächlichen Stromwerte unter 0,35 mA kann dies als Hinweis auf eine Leitungsunterbrechung, ein Stromwert von über 8 mA als Hinweis auf einen Kurzschluss ausgewertet werden.

Bei vielen Anwendungen kann die Größe des übermittelten Messsignals einen erheblichen Einfluss auf die Umgebung des Messgerätes und/oder die Umwelt haben. Insbesondere bei chemischen und umweltgefährdenden Prozessen, bei denen ein Messwert der Temperatur, des Füllstands, des Drucks, des Durchflusses oder der Zusammensetzung eines Messstoffs übermittelt wird, ist ein sicherer Ablauf des Prozesses entscheidend. Daher ist es äußerst wichtig, dass das übermittelte Messsignal tatsächlich dem gemessen Messwert entspricht. Geräte und Systeme in sicherheitsrelevanten Anwendungen müssen daher besonderen Anforderungen genügen, u. a. die Normen zur funktionalen Sicherheit (z. B. IEC 61508, IEC 61511 etc.) erfüllen. Zentraler Bestandteil der Normen zur funktionalen Sicherheit ist das sog. Safety Integrity Level (SIL). Je nach der von einem Prozess oder einer Anlage ausgehenden Gefahr wird von einer Anwendung eine entsprechende SIL-Tauglichkeit gefordert. Das SIL gibt vor, mit welcher Wahrscheinlichkeit ein auftretender Fehler eines Gerätes oder einer Anwendung detektiert wird. Dabei wird zwischen einem SIL von 1 bis 4 unterschieden, wobei 1 die niedrigste und 4 die höchste Sicherheitsstufe angibt. Aus der Offenlegungsschrift EP 1 860 513 ist eine Schaltung bekannt geworden, die gewährleisten soll, dass ein in einer Stromschleife eingestellter Strom dem tatsächlichen Wert der zu repräsentierenden Messgröße entspricht. Die Schaltung beruht auf der redundanten Einstellung des Wertes des Schleifenstroms und einer Überwachung desselben. Zwar erhöhen die im Stand der Technik verwendeten redundant ausgelegten, elektrischen, elektronischen und/oder elektronisch programmierbaren Bauteile unter Umständen die funktionale Sicherheit der Gerätschaften, aber als ein Nachteil sind die ebenso erhöhten Herstellungs- und Fertigungskosten bei einer redundanten Auslegung des Systems und der Bauteile anzusehen.

In der DE 102008001832 A1 wird vorgeschlagen, dass die Auswerteeinheit mindestens einen vom Stromregler ausgegebenen Wert der Stellgröße mit mindestens einem Referenzwert vergleicht und dass der Vergleich angibt, ob der Wert der Stellgröße den Referenzwert über- oder unterschreitet. Die vorgeschlagene Auswerteeinheit ermöglicht es, das Abweichen der Stellgröße von einem Referenzwert oder das Über- oder Unterschreiten der Stellgröße über oder unter einen vorgegebenen Referenzwert zu detektieren. Sind insbesondere zwei unterschiedliche Referenzwerte vorgesehen, so ist feststellbar, ob die Stellgröße einen der Referenzwerte überschreitet oder unterschreitet oder in einem Bereich zwischen den Referenzwerten liegt. Da sich Fehler oder Störungen der Mess- und Betriebselektronik oftmals in einem anormalen Messsignal äußern, bspw. durch übermäßige oder verminderte Spannungen und Ströme, ermöglicht die beschriebene Auswerteeinheit eine Detektion solcher anormalen Abweichungen.

Aus der DE 102004019392 A1 ist ein Messumformer bekannt, der einen Mikroprozessor umfasst mit einem Reset-Eingang und einem Taktausgang zum Bereitstellen eines periodischen Taktsignals; ferner eine Überwachungsschaltung mit einem Takt-Eingang und einem Reset-Ausgang und einen Stromregler zur Ausgabe eines Messsignalstroms, welcher Messsignalstrom im Messbetrieb in einem ersten Bandbereich einen Messwert repräsentiert und außerhalb des ersten Bandbereichs einen Fehler signalisiert; wobei der Takt-Eingang der Überwachungsschaltung mit dem Taktausgang des Mikroprozessors verbunden ist, der Reset-Eingang des Mikroprozessors mit dem Reset-Ausgang der Überwachungsschaltung verbunden ist, bei Ausfall des Taktsignals am dem Reset-Ausgang der Überwachungsschaltung ein Reset-Signal periodisch ausgegeben wird, wobei ferner der Messumformer eine Komparatorschaltung aufweist mit einem ersten Eingang, der über einen Tiefpass mit dem Reset-Ausgang der Überwachungsschaltung verbunden ist, mit einem zweiten Eingang, an dem eine Referenzspannung anliegt, und mit einen Ausgang, der mit einem Eingang des Stromreglers verbunden ist, wobei nach wiederholter Ausgabe des Reset-Signals die Spannung am ersten Eingang der Komparatorschaltung die Referenzspannung übersteigt, so dass am Ausgang des Komparators ein Stellsignal anliegt, welches den Stromregler veranlasst, einen Fehlersignalstrom außerhalb des ersten Bandbereichs auszugeben. Wie eingangs angedeutet, beträgt der erste Bandbereich für den Messsignalstrom beispielsweise 4 bis 20 mA. In diesem Falle sollte der Fehlersignalstrom mindestens 21 mA oder höchstens 3,6 mA betragen, bevorzugt wird der Fehlersignalstrom auf 22 mA geregelt.

Wie oben bereits erwähnt, ist eine ähnliche Schnittstelle für die Übertragung von Messsignalen und Statusinformationen in digitaler Form in EN 60947-5-6 (entsprechend IEC 60947-5-6) genormt. Die Betriebsparameter, dass heißt, der den digitalen Zuständen EIN und AUS zugeordnete Wert des Stromes im NAMUR-Betrieb, unterscheiden sich von den oben beschriebenen. Eine einfache und übliche Schaltung eines EN 60947-5-6-konformen Schaltverstärkers für die Übertragung von FPS-Namur-Signalen (Frequency/Pulse/Status) umfasst einen Schalttransistor mit einem Parallelwiderstand über dem Transistor zwischen den Klemmenanschlüssen des Ein-/Ausgangs und einen Serienwiderstand. Mit den genormten Betriebsparametern von 8,2 V und einem Stromwert für den EIN-Zustand von 2,2 mA bis 8 mA und einem Stromwert für den AUS-Zustand von 0,35 mA bis 1,2 mA ergeben sich typische Werte von 1 kOhm für den Serienwiderstand und 11 kOhm für den Parallelwiderstand. Liegen die tatsächlichen Stromwerte unter 0,35 mA kann dies als Hinweis auf eine Leitungsunterbrechung, Stromwerte von über 8 mA als Hinweis auf einen Kurzschluss ausgewertet werden.

Um verschiedene Anwendungen des Gerätes abdecken zu können, sollte ein Schaltverstärker nach EN 60947-5-6 im NAMUR und im Nicht-NAMUR-Betrieb verwendet werden können. Dazu sind unterschiedliche Lösungen aus dem Stand der Technik bekannt. In der einfachsten und üblichen Form ist je ein Jumper oder Kurzschlussstecker vorgesehen, mit dem der Serienwiderstand überbrückt und der Strompfad über den Parallelwiderstand unterbrochen werden kann. Im NAMUR-Betrieb ist der Jumper über dem Serienwiderstand geöffnet und der Jumper im Strompfad des Parallelwiderstandes geschlossen, bei dem Nicht-NAMUR-Betrieb umgekehrt. Dadurch kommt man mit einem Kurzschlussstecker pro Gerät aus, der ja nach Anwendung hin- und hergesteckt werden kann. Nachteilig bei dieser Lösung ist es, dass für jeden Wechsel der Betriebsart ein Servicetechniker sich zu dem Gerät begeben und in das Gerät eingreifen muss. Dies kann bei weit verteilten Geräten in großen Produktionsanlagen oder bei Geräten an exponierten Stellen sehr aufwändig sein. Außerdem muss zum Umschalten der Betriebsart das Gerätegehäuse geöffnet und elektronische Baugruppen berührt oder gar entnommen werden. Dadurch besteht die Gefahr einer Beschädigung der Geräteelektronik durch elektrostatische Entladungen oder infolge von Undichtigkeiten beim Wiederverschließen des Gehäuses. Beides kann zu Fehlfunktionen oder dem Ausfall des Gerätes führen. Weiterhin kann die Betriebselektronik den Betriebszustand nicht erfassen und damit wird eine Eigendiagnose unmöglich. Ebenfalls ist eine ferngesteuerte Umschaltung der Betriebsarten nicht möglich.

Es ist daher auch bekannt, die Jumper durch Relais zu ersetzen. Diese haben jedoch den Nachteil eines zusätzlichen Platzbedarfs, erhöhen die Leistungsaufnahme des Gerätes und damit auch die thermische Belastung der Geräteelektronik und sind aufgrund der beweglichen Bauteile verhältnismäßig empfindlich gegenüber Vibrationen. Es ist daher auch bekannt, statt der Relais Halbleiterschalter zu verwenden, die insbesondere die Vibrationsempfindlichkeit nicht aufweisen. Sie sind jedoch verhältnismäßig teuer.

Die Verwendung einer 4-20 mA NE43-Schnittsstelle, wie oben beschrieben, ist in Verbindung mit einer EN 60947-5-6 konformen Schnittstelle nicht möglich, da keine ausreichend zuverlässige Differenzierung der EIN/AUS-Zustände des EN 60947-5-6 konformen Ausgangssignals möglich ist.
Der Erfindung liegt daher die Aufgabe zugrunde, ein verbessertes Messgerät mit einer umstellbaren Mess- und Betriebselektronik zur Übermittlung eines Messsignals vorzuschlagen.
Die vorliegende Aufgabe wird durch ein Messgerät mit den Merkmalen des Anspruchs 1 und durch das Bereitstellen eines Verfahren mit den Merkmalen des Anspruchs 8 gelöst.
Ein erfindungsgemäßes Messgerät weist eine umstellbaren Mess- und Betriebselektronik auf zur Übermittlung eines Messsignals, wobei das Messgerät wenigstens einen Messumformer mit einer elektrischen Stromregelschaltung (15) umfasst zur Ausgabe eines geregelten Stromes, wobei in wenigstens einer ersten Betriebsweise ein Strom in einem ersten Strombereich einstellbar ist, und in einer wenigstens zweiten Betriebsweise ein Strom in einem zweiten Strombereich einstellbar ist, welcher zweite Strombereich ein größeres Intervall umfasst als der erste Strombereich,
wobei das Messgerät ferner eine Mikrocontrollerschaltung (13) umfasst, und die Mikrocontrollerschaltung (13) mit der elektrischen Stromregelschaltung (15) verbunden ist, wobei die Mikrocontrollerschaltung (13) mit der Stromregelschaltung (15) verbunden ist über eine Leitung (36) zur Übertragung eines digitalen Signals zur Ansteuerung der Stromregelschaltung (15), wobei das digitale Signal einen LOW und einen High Zustand aufweist und wobei durch die Ansteuerung der Stromregelschaltung durch das digitale Signal ein Ausgangsstrom mit einem Stromstärkewert in einem ersten Stromstärkenintervall für den LOW-Zustand und mit einem Stromstärkewert in einem zweiten Stromstärkenintervall für den HIGH-Zustand des digitalen Signals in der ersten Betriebsweise einstellbar ist.
Durch die geschickte Steuerung verschiedener Betriebsweisen und Stromstärkeintervallen kann eine komplizierte Widerstandsverschaltung - wie sie bislang für namurkonforme Messgeräte üblich war - entfallen.
Vorteilhafte Ausgestaltung des Anspruchs 1 sind Gegenstand der Unteransprüche.
Es ist von Vorteil, wenn der Ausgangsstrom durch das digitale Signals in der ersten Betriebsweise, derart einstellbar ist,
dass das erste Stromstärkenintervall einen unteren Grenzwert für das erste Stromstärkenintervall aufweist und einen oberen Grenzwert für das erste Stromstärkenintervall aufweist;
und dass das zweite Stromstärkenintervall einen unteren Grenzwert für
das zweite Stromstärkenintervall und einem oberen Grenzwert für das zweite Stromstärkenintervall aufweist,
wobei der obere Grenzwert des ersten Stromstärkenintervalls derart festgelegt ist, dass er einen geringeren Betrag als der untere
Grenzwert des zweiten Stromstärkenintervalls aufweist.

Der erste Strombereich kann vorteilhaft auf einen Strom zwischen 0,35 mA und wenigstens 8 mA einstellbar sein.

Der zweite Strombereich kann vorteilhaft auf einen Strom zwischen 0 mA und wenigstens 20 mA einstellbar sein.

Besonders bevorzugt weist ein Messgerät eine umstellbaren Mess- und Betriebselektronik zur Übermittlung eines Messsignals auf, wobei das Messgerät wenigstens einen Messumformer mit einer elektrischen Stromregelschaltung umfasst zur Ausgabe eines geregelten Stromes, wobei in wenigstens einer ersten Betriebsweise ein Strom zwischen 0,35 mA und wenigstens 8 mA einstellbar ist, und in einer wenigstens zweiten Betriebsweise ein Strom zwischen 0 mA und wenigstens 20 mA einstellbar ist, wobei das Messgerät ferner eine Mikrocontrollerschaltung umfasst und die Mikrocontrollerschaltung mit der elektrischen Stromregelschaltung verbunden ist, wobei die Mikrocontrollerschaltung mit der Stromregelschaltung verbunden ist über eine Leitung zur Ausgabe eines digitalen Signals zur Ansteuerung der Stromregelschaltung zur Einstellung eines Ausgangsstromes von 0,35 mA bis 1,2 mA für den LOW-Zustand und 2,2 mA bis 8 mA für den HIGH-Zustand des digitalen Signals in der ersten Betriebsweise. Durch die erfindungsgemäße Ausbildung kann das Messgerät universell eingesetzt werden und es können NAMUR-Betrieb nach EN 60947-5-6 und Nicht-NAMUR-Betrieb, sowie der Betrieb als 0 bis 20 mA-Stromschleife ohne Veränderung der Betriebselektronik durchgeführt werden. Ein Wechsel der Betriebsweisen kann dabei durch Software auch ferngesteuert durchgeführt werden. Die Erfindung erweitert den Einsatzbereich solcher Messgeräte, da nunmehr ein universelles Gerät für alle gängigen Betriebsweisen ausreicht und keine speziellen Typen produziert und vorgehalten werden müssen. Ferner kann ein Nutzer solcher Geräte auch die Betriebsweise seiner Prozesssteuerung verändern, ohne alle Messgeräte in der Anlage umrüsten oder auswechseln zu müssen.

Zweckmäßig weist die Stromregelschaltung ferner eine Strommesseinrichtung auf, die mit der Mikrocontrollerschaltung verbunden ist zur Rückführung des Istwertes des eingestellten Stromes. Dadurch wird eine Eigendiagnose der Verbindung durch das Messgerät ermöglicht.

Eine umfängliche Diagnosemöglichkeit durch eine mit dem Messgerät verbundene Prozesssteuerung ergibt sich, wenn die Stromregelschaltung in der ersten Betriebsweise gegenüber einer externen Spannungsquelle als passive Last geschaltet ist.

Insbesondere für den ferngesteuerten Wechsel der Betriebsweise ist es vorteilhaft, wenn die Verbindung zwischen Mikrocontroller und Stromregelschaltung gesonderte Leitungen zur Übermittlung von Steuersignalen zur Einstellung der Betriebsweise umfasst. Als besonderes geeignet hat sich herausgestellt, wenn die Verbindung zwischen Mikrocontroller und Stromregelschaltung vier gesonderte Leitungen zur Übermittlung von Steuersignalen zur Einstellung der Betriebsweise umfasst.

Die Aufgabe der Erfindung kann zudem durch ein Verfahren zum Betrieb einer umstellbaren Mess- und Betriebselektronik zur Übermittlung eines Messsignals gelöst werden, wobei das Messgerät wenigstens einen Messumformer mit einer elektrischen Stromregelschaltung (15) umfasst zur Ausgabe eines geregelten Stromes, wobei in wenigstens einer ersten Betriebsweise ein Strom in einem ersten Strombereich einstellbar ist, und in einer wenigstens zweiten Betriebsweise ein Strom in einem zweiten Strombereich einstellbar ist, welcher zweite Strombereich ein größeres Intervall umfasst als der erste Strombereich" und wobei die das Messgerät ferner eine Mikrocontrollerschaltung (13) umfasst und die Mikrocontrollerschaltung (13) mit der elektrischen Stromregelschaltung (15) verbunden ist, und wobei zur Ansteuerung der Stromregelschaltung (15) ein digitales Signal von der Microcontrollerschaltung übertragen wird, wobei das digitale Signal einen LOW und einen High Zustand aufweist und wobei durch die Ansteuerung der Stromregelschaltung durch das digitale Signal eine Einstellung des Ausgangsstrom durch die Stromregelschaltung (15) erfolgt, mit einem Stromstärkewert in einem ersten Stromstärkenintervall für den LOW-Zustand und mit einem Stromstärkewert in einem zweiten Stromstärkenintervall für den HIGH-Zustand des digitalen Signals in der ersten Betriebsweise.

Vorteilhafte Varianten der Erfindung snd Gegenstand der Unteransprüche.

Es ist von Vorteil wenn der Ausgangsstrom durch das digitale Signals in der ersten Betriebsweise, derart einstellbar ist,
dass das erste Stromstärkenintervall einen unteren Grenzwert für das erste Stromstärkenintervall aufweist und einen oberen Grenzwert für das erste Stromstärkenintervall aufweist;
und dass das zweite Stromstärkenintervall einen unteren Grenzwert für das zweite Stromstärkenintervall und einem oberen Grenzwert für das zweite Stromstärkenintervall aufweist,
wobei der obere Grenzwert des ersten Stromstärkenintervalls derart festgelegt ist, dass er einen geringeren Betrag als der untere
Grenzwert des zweiten Stromstärkenintervalls aufweist.

Es ist zudem von Vorteil, wenn der erste Strombereich auf einen Strom zwischen 0,35 mA und wenigstens 8 mA einstellbar wird.

Es ist zudem von Vorteil, wenn der zweite Strombereich auf einen Strom zwischen 0 mA und wenigstens 20 mA einstellbar ist.

Eine besonders bevorzugte Ausführungsvariante stellt ein Verfahren zum Betrieb einer umstellbaren Mess- und Betriebselektronik zur Übermittlung eines Messsignals dar, wobei das Messgerät wenigstens einen Messumformer mit einer elektrischen Stromregelschaltung umfasst zur Ausgabe eines geregelten Stromes, wobei in einer ersten Betriebsweise ein Strom zwischen 0,35 mA und wenigstens 8 mA einstellbar ist, und in einer zweiten Betriebsweise ein Strom zwischen 0 mA und wenigstens 20 mA einstellbar ist, wobei die das Messgerät ferner eine Mikrocontrollerschaltung umfasst und die Mikrocontrollerschaltung mit der elektrischen Stromregelschaltung verbunden ist, bei dem die Stromregelschaltung in der ersten Betriebsweise mit einem digitalen Signal zur Einstellung eines Stromes von 0,35 mA bis 1,2 mA für den LOW-Zustand und 2,2 mA bis 8 mA für den HIGH-Zustand angesteuert wird, insbesondere, wenn die Stromregelschaltung gegenüber einer externen Spannungsquelle als passive Last wirkt.

Eie Eigendiagnose durch das Messgerät wird ermöglicht, wenn der Ist-Wert des in der Stromregelschaltung eingestellten Stromes überwacht und ein Alarmsignal ausgegeben wird, wenn der Strom einen Wert von 0,35 mA unterschreitet, insbesondere einen Wert von 0,2 mA oder weniger beträgt.

Vorteilhaft ist der eingestellte Strom bei einer externen Speisespannung wenigstens im Bereich von 1,25 V, vorzugsweise von 0,4 V, bis 36 V, vorzugsweise bis 24 V, besonders bevorzugt bis 8,5 V, unabhängig von der Speisespannung.

Für den ferngesteuerten Wechsel der Betriebsweise ist es besonders vorteilhaft, wenn die Einstellung der Betriebsweise mittels Steuersignalen, vorzugsweise durch vier Steuersignale, durch unmittelbare Einwirkung auf die Komponenten der Stromregelschaltung erfolgt.

Zur näheren Erläuterung der Erfindung werden im Folgenden ein Ausführungsbeispiel der Erfindung anhand der beigefügten Zeichnungen beispielsweise beschrieben. Diese zeigen in:
- Figur 1: einen Schaltverstärkers nach dem Stand der Technik in Schaltung für einen EN 60947-5-6-konformen NAMUR-Betrieb;
- Figur 2: einen Schaltverstärkers nach dem Stand der Technik in Schaltung für einen Nicht-NAMUR-Betrieb, z.B. nach EN 1434-2-Klasse OB; und
- Figur 3: eine erfindungsgemäß umstellbaren Mess- und Betriebselektronik, umschaltbar Schaltung zwischen u.a. EN 60947-5-6-konformen (NAMUR)- und 0 bis 20 mA (Nicht-NAMUR)-Betrieb.

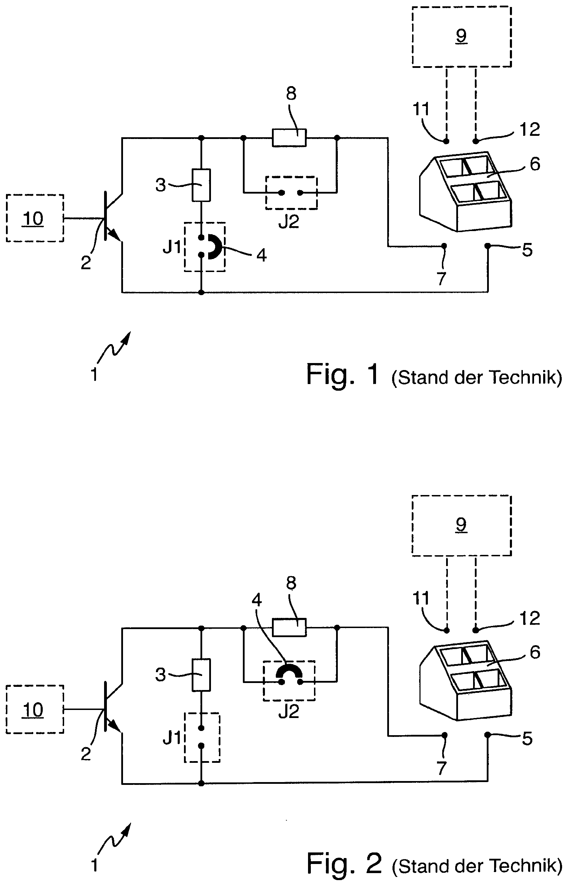

Figuren 1 und 2 zeigen einen bekannten Schaltverstärker, hier insgesamt mit 1 bezeichnet, in EN 60947-5-6-konformer Schaltung (Fig. 1), bzw. für einen "Nicht-NAMUR"-Betrieb, z.B. nach EN 1434-2-Klasse OB . Der Schaltverstärker 1 ist Teil einer elektrischen Stromregelschaltung eines Messumformers eines Messgerätes. Der Schaltverstärker 1 umfasst einen Schalttransistor 2 und einen parallel zum Schalttransistor 2 geschalteten ersten Widerstand 3, hier kurz als Parallelwiderstand 3 bezeichnet. Im Strompfad des Parallelwiderstands 3 ist ein erster Steckplatz J1 für einen Kurzschlussstecker 4, allgemein auch als Jumper bezeichnet, vorgesehen. Ist der Jumper 4 eingesteckt, wie in Fig. 1 dargestellt, ist der Parallelwiderstand 3 wie zuvor beschrieben parallel zur Kollektor-Emitterstrecke des Schalttransistors 2 geschaltet, ist der Jumper 4 entfernt, ist der Strompfad über den Parallelwiderstand 3 unterbrochen.

Bei der dargestellten Schaltung ist der Emitter des Schalttransistors 2 mit einem Anschluss 5 eines Klemmenblocks 6 verbunden. Der andere Anschluss 7 des Klemmenblocks 6 ist über einen in Reihe geschalteten Widerstand 8, hier als Serienwiderstand 8 bezeichnet, mit der Parallelschaltung aus Parallelwiderstand 3 und Kollektor des Schalttransistors 2 verbunden. Zusätzlich ist ein weiterer Steckplatz J2 für einen Kurzschlussstecker oder Jumper 4 parallel zu dem Serienwiderstand 8 geschaltet, so dass ein elektrischer Strom bei nicht eingestecktem Jumper 4, wie in Fig. 1 gezeigt, durch den Serienwiderstand 8 fließt.

Ist in den Steckplatz J2 ein Jumper 4 eingesteckt wird der Serienwiderstand 8 überbrückt und der Strom fließt über den Jumper 4, wie in Fig. 2 dargestellt.

An den Klemmenblock 6 werden die beiden Leiter der 2L-Stromschleife angeschlossen, die das Messgerät mit einer Prozesssteuerung 9 verbinden, so dass der eine Leiter mit der Leitung am Anschluss 5 und der andere Leiter mit dem Anschluss 7 an dem Klemmenblock 6 kontaktiert ist. Die Prozessteuerung 9 ist nur schematisch angedeutet. Über eine in den Figuren 1 und 2 ebenfalls nur schematisch angedeutete Vorstufe 10 des Schaltverstärkers 1 wird der Schalttransistor 2 angesteuert.

Bei der in Fig. 1 dargestellten ersten Betriebsweise des Schaltverstärkers ist über den in den Steckplatz J1 eingesteckten Jumper 4 der Parallelwiderstand 3 zum Schalttransistor 2 parallel geschaltet. Der weitere Steckplatz J2 ist leer, so dass sich der Serienwiderstand 8 im Strompfad zwischen dem Anschluss 7 und dem Schalttransistor 2 befindet. Diese Betriebsweise entspricht dem NAMUR-Betrieb nach EN 60947-5-6. Ist der Schalttransistor 2 leitend angesteuert, fließt der Strom von dem Anschluss 7 des Klemmenblocks 6 über den Serienwiderstand 8 und den Schalttransistor 2 zu dem Anschluss 5 des Klemmenblocks 6. Der durch den Spannungsabfall über dem durchgeschalteten Schalttransistor 2 verursachte parasitäre Stromfluss über den Parallelwiderstand 3 kann hierbei vernachlässigt werden. Dies bedeutet, dass der Serienwiderstand 9 den Kurzschlussstrom begrenzt.

Sperrt der Schalttransistor 2, erfolgt der Stromfluss von dem Anschluss 7 des Klemmenblocks 6 über den Serienwiderstand 8 und den Parallelwiderstand 3 zu dem Anschluss 5 des Klemmenblocks 6. Dies bedeutet, dass der Strom durch die Reihenschaltung von Serienwiderstand 9 und Parallelwiderstand 3 bestimmt wird.

Mit den genormten Betriebsparametern von 8,2 V und einem Stromwert für den HIGH-Zustand von 2,2 mA bis 8 mA und einem Stromwert für den LOW-Zustand von 0,35 mA bis 1,2 mA ergeben sich typische Werte von 1 kOhm für den Serienwiderstand 8 und 11 kOhm für den Parallelwiderstand 3.

Bei dieser Betriebsweise kann die Messung des Stromes in der Prozesssteuerung zur Überwachung der Leitung 11 zum Messgerät dienen. Liegen die tatsächlichen Stromwerte unter 0,35 mA kann dies als Hinweis auf eine Leitungsunterbrechung, bei einem Stromwert von über 8 mA als Hinweis auf einen Kurzschluss ausgewertet werden. Bei Erkennung solcher fehlerhafter Stromwerte kann durch die Prozesssteuerung ein entsprechender Alarm ausgelöst und gegebenenfalls von einem geregelten Betrieb einer Anlage auf einen Steuerungsbetrieb umgeschaltet werden.

In einer zweiten Betriebsweise, wie sie in Fig. 2 dargestellt ist, wird der Messwert durch den Wert des eingestellten Stromes repräsentiert und der Strom durch die Prozesssteuerung 9 erfasst. Der über die elektrische Stromschleife übertragene Strom liegt nach verbreitetem Industriestandard zwischen 0 mA und 20 mA.

Dazu ist der Jumper 4 von dem Steckplatz J1 entfernt und in den Steckplatz J2 eingesteckt. Der Stromfluss erfolgt von dem Anschluss 5 des Klemmenblocks 6 über den Schalttransistor 2 und unter Überbrückung des Serienwiderstands 8 durch den Jumper 4 im Steckplatz J2 zum Anschluss 7 des Klemmenblocks 6. Wie bei der ersten Betriebsweise kann das Messgerät mit der Prozessteuerung 9 vom Klemmenblock 6 über eine 2L-Leitung über Anschlüsse 11 und 12 verbunden werden.

Bei dieser Betriebsweise ist eine Funktionsüberwachung der Leitung 11 nach NAMUR-Empfehlungen nicht möglich. Nachteilig bei dieser Lösung ist es, dass für jeden Wechsel der Betriebsart ein Servicetechniker sich zu dem Gerät begeben, das Gerät öffnen und in das Gerät eingreifen muss, nämlich um den Jumper 4 in den jeweils passenden Steckplatz J1 oder J2 umzustecken. Dies kann bei weit verteilten Geräten in großen Produktionsanlagen oder bei Geräten an exponierten Stellen sehr aufwändig sein. Außerdem muss zum Umschalten der Betriebsart das Messgerätegehäuse geöffnet und elektronische Baugruppen berührt oder gar entnommen werden. Dadurch besteht die Gefahr einer Beschädigung der Geräteelektronik durch elektrostatische Entladungen oder infolge von Undichtigkeiten beim Wiederverschließen des Gehäuses. Beides kann zu Fehlfunktionen oder dem Ausfall des Gerätes führen.

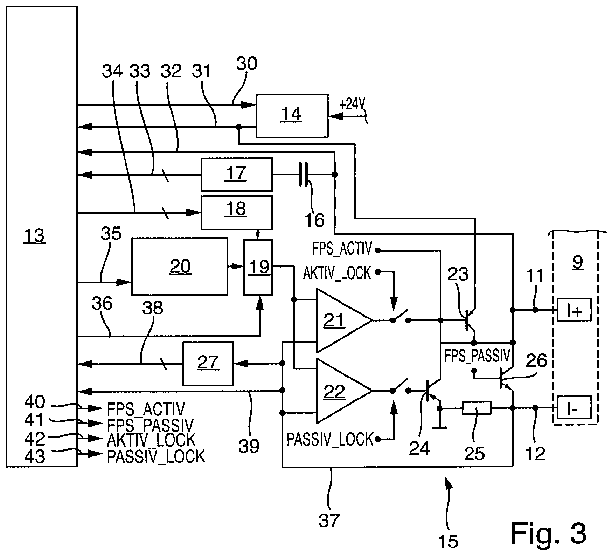

Bei der in Fig. 3 dargestellten erfindungsgemäßen Ausführung einer umstellbaren Mess- und Betriebselektronik für ein Messgerät zur Übermittlung eines Messsignals von dem Messgerät ist solch ein Eingriff zur Umstellung der Schaltung auf eine andere Betriebsweise nicht erforderlich. Vielmehr kann die Umstellung der Betriebsweise z.B. per Software erfolgen, auch ferngesteuert. Dadurch kann nicht nur der Zeit- und Arbeitsaufwand für den Servicetechniker zur Umstellung der Betriebsweise entfallen, sondern die Zuverlässigkeit der Messgeräte wird erhöht, da die Elektronik nicht durch elektrostatische Entladungen gefährdet und eine dauerhafte Dichtigkeit des Messgerätegehäuses durch den Entfall von Anlässen zum Öffnen des Gehäuses unterstützt wird. Schließlich können Messgeräte mit der erfindungsgemäßen Elektronik kompakter aufgebaut werden, da bei der Anordnung der Leiterplatten und Bauelemente keine Rücksicht mehr auf eine Zugänglichkeit von Jumpern 4 und deren Steckplätzen J1 und J2 genommen werden muss, darüber hinaus können die Widerstände 3 und 8 sowie die Steckplätze J1 und J2 entfallen.

Besonders vorteilhaft ist es bei der erfindungsgemäßen Lösung, dass eine Umstellung der Betriebsweise der Elektronik praktisch jederzeit und beliebig häufig erfolgen kann, so dass Daten über verschiedene Übertragungsprotokolle nahezu gleichzeitig übertragen werden können.

Der Messumformer gemäß der Erfindung umfasst eine Mikrocontrollerschaltung, hier in Form eines integrierten Mikrocontrollers 13. Die Beschaltung des Mikrocontrollers 13 ist beschränkt und vereinfacht als Blockschaltbild dargestellt zur Erläuterung der Erfindung. Weitere Beschaltung, z.B. für die Kommunikation über einen Feldbus, kann in üblicher Weise erfolgen. Der dargestellte Messumformer umfasst einen sogenannten Step-Down-Wandler 14 zur Bereitstellung einer Gleichspannung, die aus der internen Versorgungsspannung von typischer Weise 24 V Gleichspannung gewonnen wird. Die Ausgangsspannung des Step-Down-Wandlers 14 kann über die Leitung 30 durch den Mikrocontroller 13 gesteuert und der Ausgang des Step-Down-Wandlers 14 über die Leitung 31 überwacht werden. Der Ausgang des Step-Down-Wandlers 14 ist ferner mit der Stromregelschaltung, insgesamt mit 15 bezeichnet, verbunden. Die Einstellung der Ausgangsspannung des Step-Down-Wandlers 14 dient zur Anpassung an die Betriebsparameter des aktuellen Betriebszustandes und kann auch zur Begrenzung der Verlustleistung in der Stromregelschaltung 15 abgesenkt werden.

Die Mess- und Betriebselektronik des Messgerätes, speziell der Messumformer, ist über die Anschlüsse 11 und 12 an eine Stromschleife angeschlossen. Der externe Teil der Stromschleife wird durch die Prozessteuerung 9 gebildet. In der Stromschleife kann der einen Messwert repräsentierende Messsignalstrom und/oder anderer Daten in analoger oder digitaler Form eingestellt werden.

Über die Leitung 32 wird die Ausgangsspannung am Anschluss 11 überwacht. Aus dem Spannungssignal können verschiedene allgemeine Status- und Diagnoseinformationen abgeleitet werden.

Oft ist es erforderlich, außer dem analogen elektrischen Signal oder dem digitalen FPS-Signal noch weitere Informationen, bspw. Kalibrier-, Parametrierdaten, Betriebstemperatur und - spannung usw. über die 2L-Stromschleife zu übertragen. Um diese Informationen zu übertragen, wird das Messsignal von einem höherfrequenten Signal überlagert. Ein Protokoll zur Übertragung solcher Informationen ist bspw. das HART(Highway Adressabel Remote Transducer)-Protokoll. Über einen Entkoppelungskondensator 16 und einen Bandpassfilter 17 wird das HART-Eingangsignal, das von der Prozessteuerung über die 2L-Leitung bereitgestellt wird, von dem Anschluss 11 abgegriffen, ausgekoppelt und über die Leitung 33 dem Mikrocontroller 13 zur Decodierung und Auswertung zugeführt.

Ein HART-Ausgangssignal wird über die Leitung 34 von dem Mikrocontroller 13 ausgegeben und als Digital-Analog gewandeltes Signal in einem Pseudo-Sinusgenerator 18 aufbereitet an einen Mischer 19 übergeben. Ein weiteres Eingangssignal wird dem Mischer 19 von dem Digital-Analog-Wandler (DAC) 20 zugeführt. Dieser DAC 20, hier als separates Schaltungselement dargestellt, gibt ein den Messwert repräsentierendes Signal aus. Über den Leitungssatz 35 wird das Signal von dem Mikrocontroller 13 z.B. als pulsweitenmoduliertes Signal ausgegeben. Ein FPS-Namur-Signal (Frequency/Pulse/Status) kann über die Leitung 36 im Bedarfsfalle direkt dem Mischer 19 zugeführt werden.

Der Mischer 19 stellt an seinem Ausgang ein dem Sollwert des in der Stromschleife einzustellenden Stromes entsprechendes Signal zur Verfügung. Der Ausgang des Mischers 19 ist mit den Eingängen von zwei Operationsverstärkern (OPAMP) 21, 22 verbunden, die die Vorstufe 10 der Stromregelschaltung 15 bilden. Der erste OPAMP 21 steuert einen ersten Transistor 23 der Stromregelschaltung 15 an. Der Emitter des ersten Transistors 23 ist mit dem Ausgang des Step-Down-Wandlers 14 verbunden, der Kollektor mit dem Plus-Anschluss 11 der Stromschleife. Der zweite OPAMP 22 steuert einen zweiten Transistor 24, dessen Kollektor mit dem Plus-Anschluss 11 der Stromschleife und dessen Emitter mit der Masse verbunden ist. Zwischen Masse und dem Minus-Anschluss 12 der Stromschleife ist ein Widerstand 25 angeordnet, der als Strommesswiderstand dient und einen entsprechend niedrigen Wert aufweist.

Zwischen Plus-Anschluss 11 und Minus-Anschluss 12 der Stromschleife ist ein dritter Transistor 26 angeordnet, wobei der Kollektor mit dem Plus-Anschluss 11 und der Emitter mit dem Minus-Anschluss 12 verbunden ist. Der Transistor 26 ist zweckmäßig mit einem nicht dargestellten Emitterwiderstand von geringem Widerstandswert von z.B. 1 Ohm beschaltet, um den durch den Transistor 26 fließenden Strom messen zu können.

Der Minus-Anschluss 12 der Stromschleife ist über eine Leitung 37 auf die invertierenden Eingänge der OPAMPs 21, 22 zurückgeführt. Ferner ist der Minus-Anschluss 12 der Stromschleife mit einem Analog-Digital-Wandler (ADC) 27 verbunden, dessen digitales Ausgangssignal ist über den Leitungssatz 38 zu einem Eingangsport des Mikrocontrollers 13 geführt. Das Spannungssignal von dem Minus-Anschluss 12 der Stromschleife kann auch noch über die Leitung 39 direkt auf einen Portanschluss des Mikrocontrollers 13 geführt werden zu einer direkten Ja/Nein -Erfassung. Abhängig von dem Strom durch den Widerstand 25 stellt sich am Minus-Anschluss 12 der Stromschleife eine Spannungsdifferenz gegenüber der Masse ein, wobei hier diese Spannungsdifferenz ausgewertet wird.

Die Funktionsweise einer Stromregelung mit Operationsverstärkern ist dem Fachmann bekannt und daher hier nicht näher erläutert,

Neben den oben beschriebenen Ausgängen verfügt der Mikrocontroller 13 noch über vier weitere Ausgangsleitungen 40 bis 43, die in den beigefügten Zeichnungen der Deutlichkeit halber mit FPS_ACTIV, FPS_PASSIV, ACTIV_LOCK und PASSIV_LOCK bezeichnet sind. Die Leitung 40 (FPS_ACTIV) führt zur Basis des ersten Transistors 23, die Leitung 41 (FPS_PASSIV) zur Basis des dritten Transistors 26.

Die Leitungen 42 und 43 (entsprechend ACTIV_LOCK und PASSIV_LOCK) führen zu Steuereingängen an den OPAMPs 21 bzw. 22. Liegt der Pegel am Ausgang 42 (ACTIV_LOCK) auf LOW (0 V) oder ist der Ausgang 42 hochohmig, kann der OPAMP 21 den ersten Transistor 23 nicht ansteuern. Liegt der Pegel auf HIGH (+ 3 V), kann der OPAMP 21 den Transistor 23 ansteuern. In ähnlicher Weise kann der OPAMP 22 den zweiten Transistor 24 nicht ansteuern, wenn der Pegel am Ausgang 43 (PASSIV_LOCK) auf HIGH (+ 3 V) liegt oder hochohmig ist. Liegt der Pegel jedoch auf LOW (0 V), kann der OPAMP 22 den Transistor 24 ansteuern. Daher sind diese Eingänge der OPAMPs 22, 23 als Schalter in der Zeichnung symbolisiert.

In einer ersten Betriebsweise entsprechend dem NAMUR-Betrieb nach EN 60947-5-6 wird von der Mikrocontrollerschaltung 13 über die Leitung 36 ein digitales FPS-Namur-Signal (Frequency/Pulse/Status) direkt dem Mischer 19 zugeführt. Die Leitung 40 (FPS_ACTIV) zur Basis des ersten Transistors 23 und die Leitung 41 (FPS_PASSIV) zur Basis des dritten Transistors 26 liegen auf 0 V. Dadurch sind die Transistoren 23 und 26 gesperrt. Die Stromschleife wird von der Prozessteuerung 9 als externer Spannungsquelle gespeist und führt von dem Anschluss 11 über den Transistor 24 und den Strommesswiderstand 25, sowie den Anschluss 12 wieder zur Prozesssteuerung 9. Entsprechend liegt das Signal auf der Leitung 42 (ACTIV_LOCK) auf LOW (0 V) und der OPAMP 21 kann den ersten Transistor 23 nicht ansteuern. Die Leitung 43 (PASSIV_LOCK) liegt ebenfalls auf LOW (0 V) und der OPAMP 22 kann den Transistor 24 ansteuern. Die Stromregelschaltung 15 wirkt daher auf die Prozessteuerung 9 als externer Spannungsquelle wie eine passive Last. Der OPAMP 22 erhält sein Eingangssignal vom Mischer 19, so dass die Stromregelschaltung 15 den Ausgangsstrom auf einen Wert von 0,35 mA bis 1,2 mA für den LOW-Zustand des FPS-Namur-Signals und 2,2 mA bis 8 mA für den HIGH-Zustand des digitalen FPS-Namur-Signals einstellt.

Über den Strommesswiderstand 25 fällt dabei eine Spannung entsprechend des Stromes ab nach der Formel U = R x I mit U= Spannung in Volt, R= Widerstandswert des Strommesswiderstands 25 in Ohm und I= Wert des tatsächlich durch den Strommesswiderstand 25 fließenden Stromes in Ampere. Diese gegenüber der Bezugsmasse am Emitterausgang des Transistors 24 negative Spannung wird über die Leitung 37 auf den invertierenden Eingang des OPAMP 22 zurückgeführt zur Regelung des Stromes und zu dem Eingang des Analog-Digital-Wandlers (ADC) 27. Das digitalisierte Signal wird über die Leitung 38 dem Mikrocontroller 13 zugeführt. Dadurch kann der Ist-Wert des Stroms durch die Stromschleife durch die Software im Mikrocontroller 13 ausgewertet werden. Entspricht das erhaltene Signal einem Wert des tatsächlich fließenden Stromes von weniger als 0,35 mA, insbesondere weniger als 0,2 mA, ist dieses ein Zeichen für eine Unterbrechung der Stromschleife, z.B. durch einen Leitungsbruch der Verbindung zur Prozesssteuerung 9. Da in einem solchen Falle die Verbindung von der Prozessteuerung 9 als externer Spannungsquelle für die Stromschleife fehlt, kann der Strom unabhängig von der Einwirkung des OPAMPs 22 auf den Transistor 24 keinen nennenswerten Wert annehmen. Ähnliches gilt auch für einen Kurzschluss in der Leitung zur Prozesssteuerung 9, da in einem solchen Fall die Spannung über die Kurzschlussstelle abgebaut wird. Somit kann ein Fehlerzustand (Leitungsunterbrechung oder Kurzschluss) nicht nur durch die Prozesssteuerung 9 erkannt werden, sondern auch durch die Betriebselektronik des Messgerätes. Auch wenn diese Eigendiagnosefähigkeit der Betriebselektronik eine Unterscheidung in Leitungsunterbrechung und Kurzschluss nicht ermöglicht, kann von dem Messgerät unmittelbar ein Alarmsignal ausgegeben werden. Somit können z.B. in der Nähe des Messgerätes befindliche Personen unmittelbar die notwendigen Maßnahmen durchführen, z.B. eine Handsteuerung eines Prozesses übernehmen.

In einer weiteren Betriebsweise, Stromausgang passiv, entspricht der Strompfad der Stromschleife dem zuvor beschriebenen. Hierzu wird über den Leitungssatz 35 ein den Messwert repräsentierendes Signal von dem Mikrocontroller 13 z.B. als pulsweitenmoduliertes Signal an den DAC 20 ausgegeben. Dieser DAC 20, hier als separates Schaltungselement dargestellt, gibt ein den Messwert repräsentierendes analoges Signal an den Mischer 19 aus. Das Ausgangssignal des Mischers 19 wird wie zuvor beschrieben an den OPAMP 22 ausgegeben und der Strom in der Stromschleife wird entsprechend eingeregelt. Über die Auswertung des tatsächlichen Stromflusses kann eine Korrektur des PWM-Signals und damit eine äußere Regelung des Stromes erfolgen, falls erforderlich.

In einer weiteren Betriebsweise, Status-Eingang mit Laststrom, entspricht der Strompfad der Stromschleife dem zuvor beschriebenen. Dabei wird über den PWM-Ausgang 35 ein vorbestimmter fester Laststrom in der Stromschleife vorgegeben und über den OPAMP 22 in der Stromschleife eingestellt. Über die Leitung 32 werden Spannungsänderungen an dem Anschluss 11 erfasst und an den Mikrocontroller 13 übergeben und ausgewertet. Bei dieser Betriebsweise ist es möglich, das Verhalten früher üblicher Status-Eingänge, insbesondere solcher mit nichtlinearen Kennlinien, für den Einsatz in bestehenden Prozessteuerungsanlagen zu simulieren.

In einer weiteren Betriebsweise, Stromeingang passiv, entspricht der Strompfad der Stromschleife dem zuvor beschriebenen. Hierzu wird über den Leitungssatz 35 ein einen Maximalstrom, z.B. 25 mA, repräsentierendes Signal von dem Mikrocontroller z.B. als pulsweitenmoduliertes Signal an den DAC 20 ausgegeben. Dieser DAC 20, hier als separates Schaltungselement dargestellt, gibt ein entsprechendes analoges Signal an den Mischer 19 aus. Das Ausgangssignal des Mischers 19 wird wie zuvor beschrieben an den OPAMP 22 ausgegeben. Da der tatsächliche Strom normalerweise unterhalb des Maximalstroms liegt, arbeitet der OPAMP 22 in der Sättigung. Steigt der Strom in der Stromschleife über den Maximalwert, beginnt der Transistor 24 zu sperren und verhindert damit einen weiteren Stromanstieg. Der Schwellwert für den Maximalstrom kann durch Änderung des Taktverhältnisses des PWM-Signals verändert werden. Der Strom in der Stromschleife wird wie zuvor beschrieben gemessen und entsprechend ausgewertet.

In einer weiteren Betriebsweise, Status-Eingang hochohmig, wird das Signal auf der Leitung 43 (PASSIV_LOCK) auf HIGH (+ 3 V) gesetzt und der OPAMP 22 kann den Transistor 24 nicht ansteuern. Die Stromregelschaltung 15 ist damit deaktiviert. Die Spannung am Anschluss 11 wird wie bei der Betriebsweise "Status-Eingang mit Laststrom" gemessen und ausgewertet.

In einer weiteren Betriebsweise, Stromeingang aktiv, ist die Stromregelschaltung ähnlich konfiguriert, wie in der Betriebsweise "Stromeingang passiv". Jedoch ist in diesem Falle das Signal auf der Leitung 43 (PASSIV_LOCK) auf HIGH (+ 3 V) gesetzt und der OPAMP 22 kann den Transistor 24 nicht ansteuern. Jedoch liegt der Pegel am Ausgang 42 (ACTIV_LOCK) ebenfalls auf HIGH (+ 3 V) und der OPAMP 21 kann den Transistor 23 ansteuern. Als Spannungsquelle dient dabei der interne Step-Down-Wandler 14, der über die Leitung 30 vom Mikrocontroller 13 angesteuert wird. Über den Leitungssatz 35 wird ein einen Maximalstrom, z.B. 25 mA, repräsentierendes Signal von dem Mikrocontroller z.B. als pulsweitenmoduliertes Signal an den DAC 20 ausgegeben. Dieser DAC 20, hier als separates Schaltungselement dargestellt, gibt ein entsprechendes analoges Signal an den Mischer 19 aus. Das Ausgangssignal des Mischers 19 wird wie zuvor beschrieben an den OPAMP 21 ausgegeben. Da der tatsächliche Strom normalerweise unterhalb des Maximalstroms liegt, arbeitet der OPAMP 21 in der Sättigung. Steigt der Strom in der Stromschleife über den Maximalwert, beginnt der Transistor 23 zu sperren und verhindert damit einen weiteren Stromanstieg. Der Schwellwert für den Maximalstrom kann durch Änderung des Taktverhältnisses des PWM-Signals verändert werden. Der Strom in der Stromschleife wird wie zuvor beschrieben gemessen und entsprechend ausgewertet, wobei die über dem Strommesswiderstand 25 abfallende Spannung in diesem Fall einen positiven Wert annimmt.

In einer weiteren Betriebsweise, Stromausgang aktiv, dient hier dabei der interne Step-Down-Wandler 14 als Spannungsquelle, der über die Leitung 30 vom Mikrocontroller angesteuert wird. In diesem Falle ist das Signal auf der Leitung 43 (PASSIV_LOCK) auf HIGH (+ 3 V) gesetzt und der OPAMP 22 kann den Transistor 24 nicht ansteuern. Der Pegel am Ausgang 42 (ACTIV_LOCK) liegt ebenfalls auf HIGH (+ 3 V) und der OPAMP 21 kann den Transistor 23 ansteuern. Über den Leitungssatz 35 wird ein den Messwert repräsentierendes Signal von dem Mikrocontroller z.B. als pulsweitenmoduliertes Signal an den DAC 20 ausgegeben. Dieser DAC 20, hier als separates Schaltungselement dargestellt, gibt ein den Messwert repräsentierendes analoges Signal an den Mischer 19 aus. Das Ausgangssignal des Mischers 19 wird an den OPAMP 21 ausgegeben und der Strom in der Stromschleife wird entsprechend eingeregelt. Der Strom in der Stromschleife wird wie zuvor beschrieben gemessen und entsprechend ausgewertet, wobei die über dem Strommesswiderstand 25 abfallende Spannung in diesem Fall einen positiven Wert annimmt. Dabei erfolgt die Rückführung des Spannungswertes von dem Strommesswiderstand 25 an den invertierenden Eingang des OPAMPs 21. Über die Auswertung des tatsächlichen Stromflusses kann eine Korrektur des PWM-Signals und damit eine äußere Regelung des Stromes erfolgen, falls erforderlich. Auch hier ist eine Eigendiagnose möglich. Kann nämlich der vorgegebenen Stromwert nicht eingeregelt werden, sondern die Spannung am Anschluss 12 ist annähernd Null, liegt eine Leitungsunterbrechung in der Stromschleife vor.

In einer weiteren Betriebsart, FPS aktiv, sind das Signal auf der Leitung 43 (PASSIV_LOCK) auf HIGH (+ 3 V) und das Signal auf der Leitung 42 (ACTIV_LOCK) auf LOW (0 V) gesetzt, so dass durch die OPAMPs 21 und 22 weder der Transistor 23, noch der Transistor 24 angesteuert werden kann. Der Transistor 23 wird über das getaktete Signal auf der Leitung 40 (FPS_ACTIV) direkt im Schaltbetrieb angesteuert, über das invertierte FPS-Signal auf der Leitung 41 (FPS_PASSIV) wird der Transistor 26 im Gegentaktbetrieb angesteuert. Der Strom durch die Stromschleife kann ebenfalls wie zuvor beschrieben gemessen und ausgewertet werden.

In einer weiteren Betriebsart, FPS passiv, sind ebenfalls das Signal auf der Leitung 43 (PASSIV_LOCK) auf HIGH (+ 3 V) und das Signal auf der Leitung 42 (ACTIV_LOCK) auf LOW (0 V) gesetzt, so dass durch die OPAMPs 21 und 22 weder der Transistor 23, noch der Transistor 24 angesteuert werden können. Das Signal auf der Leitung 40 (FPS_ACTIV) liegt auf LOW (0 V). Der Transistor 26 wird durch das FPS-Signal direkt im Schaltbetrieb angesteuert. Die Spannungsquelle in der Stromschleife wird durch die Prozesssteuerung 9 gebildet. Übersteigt die Spannung am Anschluss 11, die über die Leitung 32 erfasst werden kann, die Spannung am Anschluss 12, die über die Leitung 37 und den ADC 27 erfasst werden kann, um einen Wert von etwa 0,8 V, hat der Transistor 26 vom Schaltbetrieb in den Linearbetrieb gewechselt. Bei Erkennung dieses Zustands kann durch den Mikrocontroller 13 eine Alarmsignal ausgegeben und der Ausgangsstrom abgeschaltet werden, um eine Zerstörung des Transistors 26 durch thermische Überlastung zu vermeiden.

Neben der im Vorstehenden beschriebenen und in den Figuren gezeigten Ausführungsvariante eines Messgerätes mit einer umstellbaren Mess- und Betriebselektronik zur Übermittlung eines Messsignals, insbesondere mit einem Messumformer, können i m Rahmen der Erfindung noch zahlreiche weitere vorgesehen werden, bei denen eine Stromregelschaltung sowohl einen Regelbereich von 0 mA bis 20 mA aufweist, als auch einen Betrieb als Schaltverstärker im Nicht-Namur-Betrieb (z.B. passiver Pulse nach EN1434, Klasse OB) und im NAMUR-Betrieb nach EN 60947-5-6 erlaubt.

### Bezugszeichenliste

- 1: Schaltverstärker
- 2: Schalttransistor
- 3: Parallelwiderstand
- 4: Kurzschlussstecker (Jumper)
- 5: Anschluss von 6
- 6: Klemmenblock
- 7: Anschluss von 6
- 8: Serienwiderstand
- 9: Prozesssteuerung
- 10: Vorstufe
- 11: Anschluss für 2L-Leitung
- 12: Anschluss für 2L-Leitung
- 13: Mikrocontroller
- 14: Step-Down-Wandler
- 15: Stromregelschaltung
- 16: Entkoppelungskondensator
- 17: Bandpassfilter
- 18: Pseudo-Sinusgenerator
- 19: Mischer
- 20: Digital-Analog-Wandler (DAC)
- 21: Operationsverstärker
- 22: Operationsverstärker
- 23: erster Transistor
- 24: zweiter Transistor
- 25: Strommesswiderstand
- 26: dritter Transistor 26
- 27: Analog-Digital-Wandler (ADC)
- 28: -
- 29: -
- 30: Leitung (Ansteuerung Step-Down-Wandler)
- 31: Leitung (Ausgang Step-Down-Wandler)
- 32: Leitung (Überwachung Ausgangsspannung)
- 33: Leitungssatz (HART-Eingang)
- 34: Leitungssatz (HART-Ausgang)
- 35: Leitungssatz (PWM-Signal)
- 36: Leitung (FPS-Namur-Signal)
- 37: Leitung (Rückführung)
- 38: Leitungssatz (Istwert Schleifenstrom, digital)

## Patentansprüche

1. Messgerät mit einer umstellbaren Mess- und Betriebselektronik zur Übermittlung eines Messsignals, wobei das Messgerät wenigstens einen Messumformer mit einer elektrischen Stromregelschaltung (15) umfasst zur Ausgabe eines geregelten Stromes, wobei in wenigstens einer ersten Betriebsweise ein Strom in einem ersten Strombereich einstellbar ist, und in einer wenigstens zweiten Betriebsweise ein Strom
in einem zweiten Strombereich einstellbar ist, welcher zweite Strombereich ein größeres Intervall umfasst als der erste Strombereich,
wobei das Messgerät ferner eine Mikrocontrollerschaltung (13) umfasst, und die Mikrocontrollerschaltung (13) mit der elektrischen Stromregelschaltung (15) verbunden
ist, wobei
die Mikrocontrollerschaltung (13) mit der Stromregelschaltung (15) verbunden ist über
eine Leitung (36) zur Übertragung eines digitalen Signals zur Ansteuerung der Stromregelschaltung (15),
**dadurch gekennzeichnet, dass**
das digitale Signal einen LOW und einen High Zustand aufweist und
durch die Ansteuerung der Stromregelschaltung durch das digitale Signal ein Ausgangsstrom mit einem Stromstärkewert in einem ersten Stromstärkenintervall für den LOW-Zustand und mit einem Stromstärkewert in einem zweiten Stromstärkenintervall für den HIGH-Zustand des digitalen Signals in der ersten Betriebsweise einstellbar ist, und der zweite Strombereich auf einen Strom zwischen 0 mA und wenigstens 20 mA einstellbar ist,
und die Übertragung des digitalen Signals zur Ansteuerung der Stromregelschaltung (15) die Einstellung des Ausgangsstromes von 0,35 mA bis 1,2 mA für das erste Stromstärkenintervall im LOW-Zustand des digitalen Signals in der ersten Betriebsweise und von 2,2 mA bis 8 mA für das zweite Stromstärkenintervall im HIGH-Zustand des digitalen Signals in der ersten Betriebsweise ermöglicht.

2. Messgerät nach Anspruch 1, **dadurch gekennzeichnet, dass** der Ausgangsstrom durch das digitale Signal in der ersten Betriebsweise, derart einstellbar ist,
dass das erste Stromstärkenintervall einen unteren Grenzwert für das erste Stromstärkenintervall aufweist und einen oberen Grenzwert für das erste Stromstärkenintervall aufweist; und dass das zweite Stromstärkenintervall einen unteren Grenzwert für das zweite Stromstärkenintervall und einem oberen Grenzwert
für das zweite Stromstärkenintervall aufweist,
wobei der obere Grenzwert des ersten Stromstärkenintervalls derart festgelegt ist, dass er einen geringeren Betrag als der untere
Grenzwert des zweiten Stromstärkenintervalls aufweist.

3. Messgerät nach Anspruch 1 oder 2, **dadurch gekennzeichnet, dass** der erste Strombereich auf einen Strom zwischen 0,35 mA und wenigstens 8 mA einstellbar ist.

4. Messgerät nach einem der vorhergehenden Ansprüche, **dadurch gekennzeichnet, dass** die Stromregelschaltung (15) ferner eine Strommesseinrichtung (25) aufweist, die mit der Mikrocontrollerschaltung (13) verbunden ist zur Rückführung des Istwertes des eingestellten Stromes.

5. Messgerät nach einem der vorhergehenden Ansprüche, **dadurch gekennzeichnet, dass** die Stromregelschaltung (15) in der ersten Betriebsweise gegenüber einer externen Spannungsquelle (9) als passive Last geschaltet ist.

6. Messgerät nach einem der vorhergehenden Ansprüche, **dadurch gekennzeichnet, dass** die Verbindung zwischen Mikrocontroller (13) und Stromregelschaltung (15) gesonderte Leitungen zur Übermittlung von Steuersignalen zur Einstellung der Betriebsweise umfasst.

7. Messgerät nach Anspruch 6, **dadurch gekennzeichnet, dass** die Verbindung zwischen Mikrocontroller (13) und Stromregelschaltung (15) vier gesonderte Leitungen (40, 41, 42, 43) zur Übermittlung von Steuersignalen zur Einstellung der Betriebsweise umfasst.

8. Verfahren zum Betrieb einer umstellbaren Mess- und Betriebselektronik zur Übermittlung eines Messsignals, wobei das Messgerät wenigstens einen Messumformer mit einer elektrischen Stromregelschaltung (15) umfasst zur Ausgabe eines geregelten Stromes, wobei in wenigstens einer ersten Betriebsweise ein Strom in einem ersten Strombereich einstellbar ist, und in einer wenigstens zweiten Betriebsweise ein Strom in einem zweiten Strombereich einstellbar ist, welcher zweite Strombereich ein größeres Intervall umfasst als der erste Strombereich, und wobei die das Messgerät ferner eine Mikrocontrollerschaltung (13) umfasst und die Mikrocontrollerschaltung (13) mit der elektrischen Stromregelschaltung (15) verbunden ist,
und wobei zur Ansteuerung der Stromregelschaltung (15) ein digitales Signal von der Microcontrollerschaltung übertragen wird, **dadurch gekennzeichnet, dass** das digitale Signal einen LOW
und einen High Zustand aufweist und wobei durch die Ansteuerung der Stromregelschaltung durch das digitale Signal eine Einstellung des Ausgangsstrom durch die Stromregelschaltung (15) erfolgt, mit einem Stromstärkewert in einem ersten Stromstärkenintervall für den LOW-Zustand und mit einem Stromstärkewert in einem zweiten Stromstärkenintervall für den HIGH-Zustand des digitalen Signals in der ersten Betriebsweise, und der zweite Strombereich auf einen Strom zwischen 0 mA und wenigstens 20 mA einstellbar ist,
und die Übertragung des digitalen Signals zur Ansteuerung der Stromregelschaltung (15) die Einstellung des Ausgangsstromes von 0,35 mA bis 1,2 mA für das erste Stromstärkenintervall im LOW-Zustand des digitalen Signals in der ersten Betriebsweise und von 2,2 mA bis 8 mA für das zweite Stromstärkenintervall im HIGH-Zustand des digitalen Signals in der ersten Betriebsweise ermöglicht.

9. Verfahren nach Anspruch 8, **dadurch gekennzeichnet, dass** der Ausgangsstrom durch das digitale Signals in der ersten Betriebsweise, derart einstellbar ist, dass das erste Stromstärkenintervall einen unteren Grenzwert für das erste Stromstärkenintervall aufweist und einen oberen Grenzwert für das erste Stromstärkenintervall aufweist;
und dass das zweite Stromstärkenintervall einen unteren Grenzwert für das zweite Stromstärkenintervall und einem oberen Grenzwert für das zweite Stromstärkenintervall aufweist,
wobei der obere Grenzwert des ersten Stromstärkenintervalls derart festgelegt ist, dass er einen geringeren Betrag als der untere
Grenzwert des zweiten Stromstärkenintervalls aufweist.

10. Verfahren nach Anspruch 8 oder 9, **dadurch gekennzeichnet, dass** der erste Strombereich auf einen Strom zwischen 0,35 mA und wenigstens 8 mA einstellbar wird.

11. Verfahren nach einem der vorhergehenden Ansprüche , **dadurch gekennzeichnet, dass** die Stromregelschaltung (15) gegenüber einer externen Spannungsquelle (9) als passive Last wirkt.

12. Verfahren nach einem der vorhergehenden Ansprüche, **dadurch gekennzeichnet, dass** der Ist-Wert des in der Stromregelschaltung (15) eingestellten Stromes überwacht und ein Alarmsignal ausgegeben wird, wenn der Strom einen Wert von 0,35 mA unterschreitet, insbesondere einen Wert von 0,2 mA oder weniger beträgt.

13. Verfahren nach einem der vorhergehenden Ansprüche, **dadurch gekennzeichnet, dass** der eingestellte Strom bei einer externen Speisespannung wenigstens im Bereich von 1,25 V, vorzugsweise von 0,4 V, bis 36 V, vorzugsweise bis 24 V, besonders bevorzugt bis 8,5 V, unabhängig von der Speisespannung ist.

14. Verfahren nach einem der vorhergehenden Ansprüche, **dadurch gekennzeichnet, dass** die Einstellung der Betriebsweise mittels Steuersignalen, vorzugsweise durch vier Steuersignale, durch unmittelbare Einwirkung auf die Komponenten (21, 22, 23, 26) der Stromregelschaltung (15) erfolgt.

## Claims

1. Measuring device with adaptable measuring and operating electronics to transmit a measuring signal, wherein the measuring device has at least one transmitter with an electrical current control circuit (15) for outputting a regulated current, wherein in at least a first mode of operation a current can be adjusted in a first current range, and wherein in at least a second mode of operation a current can be adjusted in a second current range, said second current range having a larger interval than the first current range,
wherein the measuring device further comprises a microcontroller circuit (13) and wherein the microcontroller circuit (13) is connected to the electrical current control circuit (15),
said microcontroller circuit (13) being connected to the current control circuit (15) via a wire (36) for the transmission of a digital signal to activate the current control circuit (15),
**characterized in that**
the digital signal has a low and a high state and, with the activation of the current control circuit by the digital signal, it is possible to adjust an output with a current strength value in a first current strength interval for the LOW state and with a current strength value in a second current strength interval for the HIGH state of the digital signal in a first mode of operation,
and the second current range can be set to a current between 0 mA and at least 20 mA,
and the transmission of the digital signal to activate the current control circuit (15) enables the setting of the output current from 0.35 mA to 1.2 mA for the first current strength interval in the LOW state of the digital signal in the first mode of operation and of 2.2 mA to 8 mA for the second current strength interval in the HIGH state of the digital signal in the first mode of operation.

2. Measuring device as claimed in Claim 1, **characterized in that** the output current can be adjusted by the digital signal in the first mode of operation in such a way that the first current strength interval has a lower limit value for the first current strength interval and an upper limit value for the first current strength interval; and **in that** the second current strength interval has a lower limit value for the second current strength interval and an upper limit value for the second current strength interval, wherein the upper limit value of the first current strength interval is specified in such a way that it has a lower value than the lower limit value of the second current strength interval.

3. Measuring device as claimed in Claim 1 or 2, **characterized in that** the first current range can be set to a current between 0.35 mA and at least 8 mA.

4. Measuring device as claimed in one of the previous claims, **characterized in that** the current control circuit (15) further comprises a current measuring unit (25), which is connected to the microcontroller circuit (13) and is used to return the actual value of the set current.

5. Measuring device as claimed in one of the previous claims, **characterized in that**, in the first mode of operation, the current control circuit (15) is switched as a passive load in relation to an external voltage source (9).

6. Measuring device as claimed in one of the previous claims, **characterized in that** the connection between the microcontroller (13) and the current control circuit (15) comprises separate wires for the transmission of control signals to set the mode of operation.

7. Measuring device as claimed in Claim 6, **characterized in that** the connection between the microcontroller (13) and the current control circuit (15) comprises four separate wires (40, 41, 42, 43) for the transmission of control signals to set the mode of operation.

8. Procedure designed for the operation of adjustable measuring and operating electronics for the transmission of a measuring signal, wherein the measuring device comprises at least one transmitter with an electrical current control circuit (15) for outputting a regulated current, wherein in at least a first mode of operation a current can be adjusted in a first current range, and wherein in at least a second mode of operation a current can be adjusted in a second current range, said second current range having a larger interval than the first current range,
and wherein the measuring device further comprises a microcontroller circuit (13) and wherein the microcontroller circuit (13) is connected to the electrical current control circuit (15),
and wherein a digital signal is transmitted by the microcontroller circuit to activate the current control circuit (15),
**characterized in that**
the digital signal has a LOW state and a HIGH state and wherein the activation of the current control circuit by the digital signal causes the output current to be set by the current control circuit (15), with a current strength value in a first current strength interval for the LOW state and with a current strength value in a second current strength interval for the HIGH state of the digital signal in the first mode of operation,
and the second current range can be set to a current between 0 mA and at least 20 mA,
and the transmission of the digital signal for the activation of the current control circuit (15) enables the setting of the output current from 0.35 mA to 1.2 mA for the first current strength interval in the LOW state of the digital signal in the first mode of operation and from 2.2 mA to 8 mA for the second current strength interval in the HIGH state of the digital signal in the first mode of operation.

9. Procedure as claimed in Claim 8, **characterized in that** the output current can be adjusted by the digital signal in the first mode of operation in such a way that the first current strength interval has a lower limit value for the first current strength interval and an upper limit value for the first current strength interval; and **in that** the second strength interval has a lower limit value for the second current strength interval and an upper limit value for the second current strength interval, wherein the upper limit value of the first current strength interval is specified in such a way that it has a lower value than the lower limit value of the second current strength interval.

10. Procedure as claimed in Claim 8 or 9, **characterized in that** the first current range can be set to a current between 0.35 mA and at least 8 mA.

11. Procedure as claimed in one of the previous claims, **characterized in that** the current control circuit (15) is switched as a passive load in relation to an external voltage source (9).

12. Procedure as claimed in one of the previous claims, **characterized in that** the actual value of the current set in the current control circuit (15) is monitored and an alarm signal is output if the current drops below a value of 0.35 mA, particularly a value of 0.2 mA or less.

13. Procedure as claimed in one of the previous claims, **characterized in that**, with an external supply voltage at least in the range from 1.25 V, preferably from 0.4 V, to 36 V, preferably to 24 V, particularly preferably to 8.5 V, the set current is independent of the supply voltage.

14. Procedure as claimed in one of the previous claims, **characterized in that** the mode of operation is set via control signals, preferably by four control signals, by directly influencing the components (21, 22, 23, 26) of the current control circuit (15).

## Revendications

1. Appareil de mesure doté d'une électronique de mesure et d'exploitation commutable, destiné à la transmission d'un signal de mesure, l'appareil de mesure comprenant au moins un transmetteur doté d'un circuit de régulation de courant électrique (15) destiné à fournir un courant régulé, un courant pouvant être réglé dans une première plage de courant, dans au moins un premier mode de fonctionnement, et un courant pouvant être réglé dans une deuxième plage de courant, dans au moins un deuxième mode de fonctionnement, laquelle deuxième plage de courant comprend un intervalle supérieur à celui de la première plage de courant,
l'appareil de mesure comprenant en outre un circuit à microcontrôleur (13) et le circuit à microcontrôleur (13) étant relié avec le circuit de régulation de courant électrique (15),
le circuit à microcontrôleur (13) étant relié avec le circuit de régulation de courant électrique (15) par l'intermédiaire d'un câble (36) pour la transmission d'un signal numérique destiné à la commande du circuit de régulation de courant électrique (15),
**caractérisé**
**en ce que** le signal numérique présente un état bas et un état haut et, par la commande du circuit de régulation de courant électrique via le signal numérique, un courant de sortie est réglable avec une valeur d'intensité de courant dans un premier intervalle d'intensité de courant pour l'état bas et avec une valeur d'intensité de courant dans un deuxième intervalle d'intensité de courant pour l'état haut du signal numérique dans le premier mode de fonctionnement,
et **en ce que** la deuxième plage de courant est réglable à un courant compris entre 0 mA et au moins 20 mA,
et la transmission du signal numérique pour la commande du circuit de régulation de courant (15) permettant le réglage du courant de sortie de 0,35 mA à 1,2 mA pour le premier intervalle d'intensité de courant dans l'état bas du signal numérique dans le premier mode de fonctionnement, et de 2,2 mA à 8 mA pour le deuxième intervalle d'intensité de courant dans l'état haut du signal numérique dans le premier mode de fonctionnement.

2. Appareil de mesure selon la revendication 1, **caractérisé en ce que** le courant de sortie est réglable, par l'intermédiaire du signal numérique dans le premier mode de fonctionnement, de telle sorte que le premier intervalle d'intensité de courant présente une valeur limite inférieure pour le premier intervalle d'intensité de courant et une valeur limite supérieure pour le premier intervalle d'intensité de courant ; et **en ce que** le deuxième intervalle d'intensité de courant présente une valeur limite inférieure pour le deuxième intervalle d'intensité de courant et une valeur limite supérieure pour le deuxième intervalle d'intensité de courant,
la valeur limite supérieure du premier intervalle d'intensité de courant étant définie de telle manière à présenter une valeur inférieure à la valeur limite inférieure du deuxième intervalle d'intensité de courant.

3. Appareil de mesure selon la revendication 1 ou 2, **caractérisé en ce que** la première plage de courant est réglable sur un courant compris entre 0,35 mA et au moins 8 mA.

4. Appareil de mesure selon l'une des revendications précédentes, **caractérisé en ce que** le circuit de régulation de courant (15) comprend en outre un dispositif de mesure de courant (25), qui est relié avec le circuit à microcontrôleur (13) pour le retour de la valeur réelle du courant réglé.

5. Appareil de mesure selon l'une des revendications précédentes, **caractérisé en ce que** le circuit de régulation de courant (15) est commuté dans le premier mode de fonctionnement en tant que charge passive par rapport à une source de tension externe (9).

6. Appareil de mesure selon l'une des revendications précédentes, **caractérisé en ce que** la liaison entre le microcontrôleur (13) et le circuit de régulation de courant (15) comprend des fils séparés pour la transmission des signaux de commande destinés au réglage du mode de fonctionnement.

7. Appareil de mesure selon la revendication 6, **caractérisé en ce que** la liaison entre le microcontrôleur (13) et le circuit de régulation de courant (15) comprend quatre fils séparés (40, 41, 42, 43) pour la transmission des signaux de commande destinés au réglage du mode de fonctionnement.

8. Procédé destiné à l'exploitation d'une électronique de mesure et d'exploitation commutable destinée à la transmission d'un signal de mesure, l'appareil de mesure comprenant au moins un transmetteur doté d'un circuit de régulation de courant électrique (15) destiné à fournir un courant régulé, un courant pouvant être réglé dans une première plage de courant, dans au moins un premier mode de fonctionnement, et un courant pouvant être réglé dans une deuxième plage de courant, dans au moins un deuxième mode de fonctionnement, laquelle deuxième plage de courant comprend un intervalle supérieur à celui de la première plage de courant, et l'appareil de mesure comprenant en outre un circuit à microcontrôleur (13) et le circuit à microcontrôleur (13) étant relié avec le circuit de régulation de courant électrique (15),
et un signal numérique étant transmis par le circuit à microcontrôleur (13) pour la commande du circuit de régulation de courant (15),
**caractérisé**
**en ce que** le signal numérique présente un état bas et un état haut, et un réglage du courant de sortie étant effectué par le circuit de régulation de courant (15) par le biais de la commande du circuit de régulation de courant par le signal numérique, avec une valeur d'intensité de courant dans un premier intervalle d'intensité de courant pour l'état bas et avec une valeur d'intensité de courant dans un deuxième intervalle d'intensité de courant pour l'état haut du signal numérique dans le premier mode de fonctionnement,
et **en ce que** la deuxième plage de courant est réglable sur un courant entre 0 mA et au moins 20 mA,
et **en ce que** la transmission du signal numérique destiné à la commande du circuit de régulation de courant (15) permet le réglage du courant de sortie de 0,35 mA à 1,2 mA pour le premier intervalle d'intensité de courant dans l'état bas du signal numérique dans le premier mode de fonctionnement, et de 2,2 mA à 8 mA pour le deuxième intervalle d'intensité de courant dans l'état haut du signal numérique dans le premier mode de fonctionnement.

9. Procédé selon la revendication 8, **caractérisé en ce que** le courant de sortie est réglable par le signal numérique dans le premier mode de fonctionnement, de telle sorte que le premier intervalle d'intensité de courant présente une valeur limite inférieure pour le premier intervalle d'intensité de courant et une valeur limite supérieure pour le premier intervalle d'intensité de courant ;
et **en ce que** le deuxième intervalle d'intensité de courant présente une valeur limite inférieure pour le deuxième intervalle d'intensité de courant et une valeur limite supérieure pour le deuxième intervalle d'intensité de courant,
la valeur limite supérieure du premier intervalle d'intensité de courant étant définie de telle manière à présenter une valeur inférieure à la valeur limite inférieure du deuxième intervalle d'intensité de courant.

10. Procédé selon la revendication 8 ou 9, **caractérisé en ce que** la première plage de courant est réglable sur un courant compris entre 0,35 mA et au moins 8 mA.

11. Procédé selon l'une des revendications précédentes, **caractérisé en ce que** le circuit de régulation de courant (15) agit en tant que charge passive par rapport à une source de tension externe (9).

12. Procédé selon l'une des revendications précédentes, **caractérisé en ce que** la valeur réelle du courant réglé dans le circuit de régulation de courant (15) est surveillée et un signal d'alarme est émis lorsque le courant passe sous une valeur de 0,35 mA, notamment une valeur de 0,2 mA ou moins.

13. Procédé selon l'une des revendications précédentes, **caractérisé en ce que** le courant réglé pour une tension d'alimentation externe se situe au moins dans une plage comprise entre 1,25 V, de préférence 0,4 V, et 36 V, de préférence 24 V, particulièrement de préférence 8,5 V, indépendamment de la tension d'alimentation.

14. Procédé selon l'une des revendications précédentes, **caractérisé en ce que** le réglage du mode de fonctionnement est effectué au moyen de signaux de commande, de préférence au moyen de quatre signaux de commande, par une influence directe sur les composants (21, 22, 23, 26) du circuit de régulation de courant (15).
